# EUROPÄISCHE PATENTANMELDUNG

(11) **EP 2 196 855 A1**
(43) Veröffentlichungstag der Anmeldung: **16.06.2010**
(21) Anmeldenummer: 08105966.9
(22) Anmeldetag: 10.12.2008
(51) Int. Cl.: G03F 7/20

(54) **Belichtungskopf und Verfahren zur Herstellung von Druckformen**

(71) Anmelder: CST GmbH, 47809 Krefeld (DE)
(72) Erfinder: Kesper, Peter, 47800 Krefeld (DE)
(74) Vertreter: Cohausz & Florack

(57) **Zusammenfassung**

Die Erfindung betrifft einen Belichtungskopf zum selektiven Belichten einer photosensitiven Schicht (2) einer Druckform (3) mit einem mikroelektromechanischen Spiegelsystem (4) und mit mindestens einer einen Lichtstrahl (6,7) abgebenden Lichtquelle (9,10), wobei der Lichtstrahl (6,7) auf das mikroelektromechanische Spiegelsystem (4) gelenkt ist. Die Aufgabe, einen Belichtungskopf zur Verfügung zu stellen, der einen kompakteren Aufbau ermöglicht, wird dadurch gelöst, dass die Lichtquelle (9,10) eine Leuchtdiode ist. Darüber hinaus betrifft die Erfindung ein Verfahren zur Herstellung von Druckformen, das einen schnelleren Start der Belichtung dadurch ermöglicht, dass der Lichtstrahl (6,7) von einer Leuchtdiode abgegeben wird.

## Beschreibung

Die vorliegende Erfindung betrifft einen Belichtungskopf zum selektiven Belichten einer photosensitiven Schicht einer Druckform mit einem mikroelektromechanischen Spiegelsystem und mit mindestens einer einen Lichtstrahl abgebenden Lichtquelle, wobei der Lichtstrahl auf das mikroelektromechanische Spiegelsystem gelenkt ist. Darüber hinaus betrifft die Erfindung ein Verfahren zur Herstellung von Druckformen durch selektive Belichtung deren photosensitiver Schicht mit einem Belichtungskopf, wobei ein Lichtstrahl auf ein eine Vielzahl von Mikrospiegeln umfassendes mikroelektromechanisches Spiegelsystem gelenkt wird und wobei die Mikrospiegel in Abhängigkeit von digitalen Signalen derart ausgelenkt werden, dass sie Teile des Lichtstrahl auf die Druckform reflektieren.

Belichtungsköpfe der voran stehenden Art werden beispielsweise in einer Belichtungsvorrichtung eingesetzt, wie sie im europäischen Patent EP 0 953 877 B1 beschrieben ist. Die bekannte Belichtungsvorrichtung dient zur Herstellung von Druckformen, insbesondere Siebdruckformen.

Für den Siebdruck werden üblicherweise Siebe mit definierter Maschengröße, z.B. feine Kunststoff- oder Metallgewebe, verwendet, die auf einen rechteckigen Rahmen aufgespannt werden. Es sind allerdings auch zylindrische Druckformen bekannt, bei denen sich das Sieb als zylindrischer Mantel zwischen zwei Endringen erstreckt.

Um mit einer Siebdruckform ein bestimmtes Druckmotiv drucken zu können, wird gezielt ein Teil der Maschen undurchlässig für die verwendete zähflüssige Druckfarbe gemacht. Dazu wird zunächst ganzflächig eine Schicht aus einem photosensitiven Schablonenmaterial auf das Sieb aufgetragen und die erhaltene photosensitive Schicht belichtet.

Um die Druckform mit dem zu druckenden Motiv zu belichten, ist in der EP 0 953 877 B1 vorgeschlagen worden, den Lichtstrahl einer Lichtquelle auf ein mikroelektromechanisches Spiegelsystem, das aus einer Vielzahl von einzeln ansteuerbaren Mikrospiegeln besteht, zu richten. Je nachdem, ob ein Punkt auf der Druckform belichtet werden soll oder nicht, werden diese Mikrospiegel ausgelenkt. Derartige mikroelektromechanischen Spiegelsysteme sind unter den Markennamen "Digital Micromirror Device" (DMD) der Firma Texas Instruments.

Ein DMD setzt sich aus einer Vielzahl von z.B. quadratischen Mikrospiegeln zusammen. Die Mikrospiegel können um ihre Diagonalachse in zwei stabile Positionen gekippt werden. In einem gattungsgemäßen Belichtungskopf wird das einfallende Licht in der einen Position auf die Druckform reflektiert, während es in der anderen Position auf einen Absorber gelenkt wird.

Die Einwirkung des Lichtes führt entweder zu einer Härtung der belichteten Stellen, so dass an den unbelichteten Stellen das Schablonenmaterial mit einem Lösungsmittel ausgewaschen werden kann, oder es kommt zu einer entgegen gesetzten photochemischen Reaktion mit der Folge, dass an den belichteten Stellen das Schablonenmaterial mit einem Lösungsmittel ausgewaschen werden kann. Üblicherweise reagiert das photosensitive Schablonenmaterial dabei nur auf Licht in einem bestimmten Spektralbereich.

Als Lichtquelle zum Belichten der Druckform ist in EP 0 953 877 B1 vorgeschlagen worden, Lichtstrahlen aus dem UV-Spektralbereich zu verwenden, die von einer Quecksilberdampflampe abgegeben werden.

Es hat sich gezeigt, dass das in der EP 0 953 877 B1 beschriebene Verfahren zwar grundsätzlich den in der Praxis gestellten Anforderungen genügt, die verwendeten Lichtquellen jedoch einen verhältnismäßig voluminösen Belichtungskopf bedingen. Darüber hinaus dauert es aufgrund der thermischen Trägheit der elektrodenlosen, mikrowellenangeregten Quecksilberdampflampen relativ lange bis diese einen konstanten Lichtstrahl abgeben.

Ausgehend von dem zuvor beschriebenen Stand der Technik lag der Lehre der vorliegenden Erfindung daher die Aufgabe zu Grunde, einen Belichtungskopf zur Verfügung zu stellen, der einen kompakteren Aufbau ermöglicht. Darüber hinaus sollte ein Verfahren zur Herstellung von Druckformen angegeben werden, das einen schnelleren Start der Belichtung ermöglicht.

In Bezug auf den Belichtungskopf ist die zuvor hergeleitete und aufgezeigte Aufgabe dadurch gelöst worden, dass die Lichtquelle eine Leuchtdiode ist. Eine Leuchtdiode ist auch deshalb als Lichtquelle für einen Belichtungskopf besonders geeignet, da sie eine Wärmeabfuhr über einen im Wärme leitenden Kontakt mit der Leuchtdiode stehenden, ggf. von einem Fluid durchströmten Kühler ermöglicht. Auf eine konstruktiv aufwändige Luftstromführung und Lüfter kann daher weitgehend verzichtet werden. Diese Maßnahmen können zu einer weiteren Verringerung der Abmessungen des Belichtungskopfes führen. Darüber hinaus können durch den Verzicht auf Lüfter Vibrationen des Belichtungskopfes vermieden und das Belichtungsergebnis verbessert werden. Die bei Gasentladungslampen oder thermischen Strahlern relativ geringe Aufheizgeschwindigkeit, die dazu führt, dass diese erst nach verhältnismäßig langer Zeit ein im Hinblick auf das Spektrum und die Intensität konstantes Licht abgeben, ist bei Leuchtdioden um ein Vielfaches größer. Daher kann bei einem mit Leuchtdioden ausgestatteten Belichtungskopf auch direkt mit der Belichtung begonnen werden.

Leuchtdioden zeigen außerdem im Vergleich zu Quecksilberdampflampen typischer Weise eine stabile Leistung und ein gleichbleibendes Emissionsspektrum über eine lange Betriebsdauer. Eine bei Quecksilberdampflampen notwendige Neukalibrierung des Belichtungskopfes ist daher im Rahmen der üblichen Nutzungsdauer des Belichtungskopfes bzw. der Belichtungsvorrichtung entbehrlich.

In dem Fall, dass mit dem Belichtungskopf Druckformen belichtet werden sollen, deren Abmessungen größer sind als die des mikroelektromechanischen Spiegelsystems, kann selbstverständlich der auf die Druckform gespiegelte Lichtstrahl mit Linsensystemen vergrößert werden. Soll allerdings gleichzeitig die durch die Anzahl der Mikrospiegel des mikroelektromechanischen Spiegelsystems vorgegebene Auflösung beibehalten werden, müssen unterschiedliche Abschnitte der Druckform zeitlich aufeinanderfolgend belichtet werden.

Grundsätzlich ist es dazu denkbar, mit einem nicht bewegten Belichtungskopf einen Abschnitt zu belichten, danach den Belichtungskopf und die Druckform in einer relativ zur vorigen verschobenen Anordnung zu positionieren und mit feststehendem Belichtungskopf den nächsten Abschnitt zu belichten. Auf diese Art und Weise wird das gesamte Druckmotiv quasi kachelartig zusammengesetzt.

In der Praxis hat sich allerdings gezeigt, dass der aufwändigen Mechanismus, um den Belichtungskopf mit einer ausreichenden Präzision anzuhalten und wieder zu beschleunigen, dadurch vermieden werden kann, dass Belichtungskopf und Druckform kontinuierlich relativ zueinander bewegt werden.

In dem Fall, dass die Lichtquelle ein Dauerlicht abgibt, kann dabei das Druckmotiv mit dem mikroelektromechanischen Spiegelsystem in Richtung der Relativbewegung von Belichtungskopf und Druckform zeilenweise durchgescrollt werden. Darüber hinaus ist der mit der Ansteuerung der Lichtquelle verbundene Aufwand bei Lichtquellen, die ein Dauerlicht abgeben, gering.

Demgegenüber ermöglicht eine Lichtquelle, die ein gepulstes Licht abgibt, eine mit der Bewegung der Mikrospiegel während der Belichtung einhergehende Bewegungsunschärfe ("Wischstrukturen") zu vermeiden. So können die einzelnen Mikrospiegel beispielsweise nur dann bewegt werden, wenn die Mikrospiegel gerade nicht von einem Lichtpuls beleuchtet werden.

Eine Lichtquelle die bereits einen kollimierten Lichtstrahl abgibt, ermöglicht es, lichtleistungsmindernde Elemente zur Strahlformung zu vereinfachen. So kann der Lichtstrahl beispielsweise unter Verzicht auf eine Kollimationslinse auf das mikroelektromechanische Spiegelsystem gerichtet und von dort aus auf die Druckform gelenkt werden, so dass zum Belichten der Druckform eine größere Leistung zur Verfügung steht. Da die eingebrachte Energiemenge entscheidend ist, kann bei höherer Leistung die Belichtungszeit reduziert werden.

Es hat sich gezeigt, dass insbesondere dann, wenn die Lichtquelle einen photonischen Kristall oder ein photonisches Gitter umfasst, der abgegebene Strahl im Hinblick auf die gleichmäßige Belichtung des mikroelektromechanischen Spiegelsystems optimale Strahlform aufweisen kann. Ein solches photonisches Gitter bzw. ein solcher photonischer Kristall kann beispielsweise dadurch hergestellt werden, dass in die Schicht, aus der das von der Lichtquelle, bzw. Leuchtdiode erzeugte Licht austreten soll, in einem vorher genau bestimmten Muster Vertiefungen eingebracht werden. Genauso ist es denkbar das Material dieser Schicht entsprechend zu modulieren. Derartige Lichtquellen sind beispielsweise aus der US 7,098,589 B2 bekannt. Mit diesen Maßnahmen kann auch erreicht werden, dass das in der Leuchtdiode erzeugte Licht möglichst effizient ausgekoppelt wird.

Es hat sich gezeigt, dass sich bei einer Belichtung des Schablonenmaterials mit einer mittleren Wellenlänge des von der Lichtquelle abgegebenen Lichtstrahles zwischen 280nm und 680 nm die photochemische Reaktion gut kontrollieren lässt. Insbesondere die Verwendung einer mittleren Wellenlänge zwischen 350nm und 450 nm ermöglicht dabei kurze Belichtungszeiten.

Wenn der Belichtungskopf mindestens zwei jeweils einen Lichtstrahl abgebende Lichtquellen und einen Aktuator zum Lenken jeweils eines Lichtstrahles auf das mikroelektromechanische Spiegelsystem aufweist, kann eine höhere Ausfallsicherheit gewährleistet werden. Bei dem Aktuator kann es sich beispielsweise um einen Spiegel handeln. Es ist jedoch auch möglich die Lichtquellen mit einem X-Y-Manipulator gegenüber dem mikroelektromechanischen Spiegelsystem zu verschieben, um den jeweils benötigten Lichtstrahl auf das mikroelektromechanische Spiegelsystem zu leiten.

Alternativ kann der Belichtungskopf natürlich auch mindestens zwei jeweils einen Lichtstrahl abgebende Lichtquellen umfassen, wobei die Lichtstrahlen gleichzeitig auf das mikroelektromechanische Spiegelsystem gelenkt sind. Die gleichzeitige Lenkung der Lichtstrahlen auf das mikroelektromechanische Spiegelsystem, schließt dabei nicht aus, dass beide Lichtquellen zu unterschiedlichen Zeiten Licht abgeben. Insbesondere in dem Fall, dass die Lichtquellen gepulstes Licht abgeben, können die Lichtquellen derart synchronisiert sein, dass die Lichtpulse abwechselnd auf das mikroelektromechanische Spiegelsystem treffen. Die Verwendung zweier gleichzeitig auf das mikroelektromechanische Spiegelsystem gerichteter Lichtstrahlen erweist sich insbesondere dann als vorteilhaft, wenn die von einer Lichtquelle abgegebene Intensität für eine kurze Belichtungszeit nicht ausreichend ist. Die Lichtstrahlen können bei dem derart gestalteten Belichtungskopf entweder auf denselben oder einen unterschiedlichen Abschnitt des mikroelektromechanischen Spiegelsystems gerichtet sein.

Bei einem Belichtungskopf mit mindestens zwei Lichtquellen können sich die mittleren Wellenlängen der von den mindestens zwei Lichtquellen abgegebenen Lichtstrahlen auch unterscheiden. Die Maßnahme ermöglicht es, denselben Belichtungskopf zur Belichtung von verschiedenen Druckformen zu verwenden, deren photosensitive Schichten unterschiedliche spektrale Empfindlichkeiten haben.

Mit den unterschiedlichen Wellenlängen kann aber nicht nur auf unterschiedliche photosensitive Schichten reagiert werden, sondern es ist auch möglich auf die Tiefenstruktur der photosensitiven Schicht Einfluss zu nehmen. Beispielsweise führen Lichtstrahlen mit einer kürzeren mittleren Wellenlänge, insbesondere mit einer Wellenlänge von weniger als 400 nm, zu einer photochemischen Reaktion überwiegend im oberflächennahen Bereich der photosensitiven Schicht. Demgegenüber dringen langwelligere Lichtstrahlen tiefer in die Schicht ein und führen zu einer über die Tiefe gleichmäßigeren Härtung der Schicht. Die für die chemische Reaktion benötigte Reaktionszeit ist bei langwelligeren Lichtstrahlen allerdings erhöht. Durch den gezielten Einsatz von Lichtstrahlen unterschiedlicher Wellenlänge, die entweder gleichzeitig oder zeitlich aufeinanderfolgend auf die Druckform gerichtet werden, kann somit unter Berücksichtigung der voran stehend genannten Wirkungen der unterschiedlichen Wellenlängen eine in der Praxis optimale Druckform hergestellt werden.

Hinsichtlich des Verfahrens besteht die Lösung der eingangs gestellten Aufgabe darin, dass als Lichtquelle eine Leuchtdiode verwendet wird. Bezüglich der damit einhergehenden Vorteile wird auf die Ausführungen zum entsprechenden Belichtungskopf gemäß Anspruch 1 verwiesen.

Die Verwendung von mindestens zwei Leuchtdioden ermöglicht darüber hinaus die folgenden vorteilhaften Ausgestaltungen des Verfahrens:

Gemäß einer ersten Ausgestaltung des Verfahrens werden die Lichtstrahlen zeitlich aufeinanderfolgend von dem mikroelektromechanischen Spiegelsystem auf die Druckform gelenkt. Dies kann beispielsweise dadurch verwirklicht werden, dass die Lichtquellen so angesteuert werden, dass immer nur eine Lichtquelle gleichzeitig Licht abgibt. Mit dieser Ausgestaltung ist es möglich, die Druckform mit zwei unterschiedlichen Lichtstrahlen zu bearbeiten. So kann beispielsweise die photosensitive Schicht mit einem Lichtstrahl mit einer ersten Wellenlänge behandelt werden, so dass die Schicht über ihre ganze Tiefe ausreichend aushärtet, um die Maschen eines Siebdrucksiebes ausreichend zu verschließen. Anschließend kann mit einem zweiten Lichtstrahl mit einer gegenüber dem ersten Lichtstrahl geringeren Wellenlänge die Schicht an Ihrer Oberfläche gezielt nachgehärtet werden, um sie gegenüber mechanischen Einflüssen, z.B. beim Durchdrücken der Farbe durch das Sieb, widerstandsfähiger zu machen. Gerade bei dieser Vorgehensweise zeigt sich in der Praxis der Vorteil der Verwendung von Leuchtdioden anstatt Quecksilberdampflampen als Lichtquellen, da die Leuchtdioden schnellere Wechselzeiten vom leuchtenden zum nichtleuchtenden Zustand ermöglichen.

Alternativ ist es allerdings auch denkbar, dass mindestens zwei Lichtstrahlen unterschiedlicher Wellenlänge gleichzeitig von dem mikroelektromechanisches Spiegelsystem auf die Druckform gelenkt werden. Die Lichtstrahlen können dabei unterschiedliche Abschnitte des mikroelektromechanischen Spiegelsystems beleuchten. Wenn sich während der Belichtung der Belichtungskopf und die Druckform kontinuierlich relativ zueinander bewegen, ist es auf diese Art und Weise möglich, auch in dem Fall das beide Lichtquellen ein Dauerlicht abgeben, die photosensitive Schicht zunächst mit langwelligerem und anschließend mit kurzwelligerem Licht zu belichten oder umgekehrt. Durch den Verzicht auf das Abschalten steht somit bei gleicher Gesamtbelichtungsdauer eine höhere Lichtenergiemenge zum Belichten der photosensitiven Schicht zur Verfügung.

Die Lichtstrahlen unterschiedlicher Wellenlänge können allerdings auch die gleichen Abschnitte des mikroelektromechanischen Spiegelsystems beleuchten. Dies kann beispielsweise dann von Vorteil sein, wenn es sich bei dem Schablonenmaterial, aus dem die photosensitive Schicht besteht, um ein Zweikomponentensystem handelt, bei dem die eine Komponente mit Licht der einen Wellenlänge und die andere Komponente mit Licht einer anderen Wellenlänge reagiert.

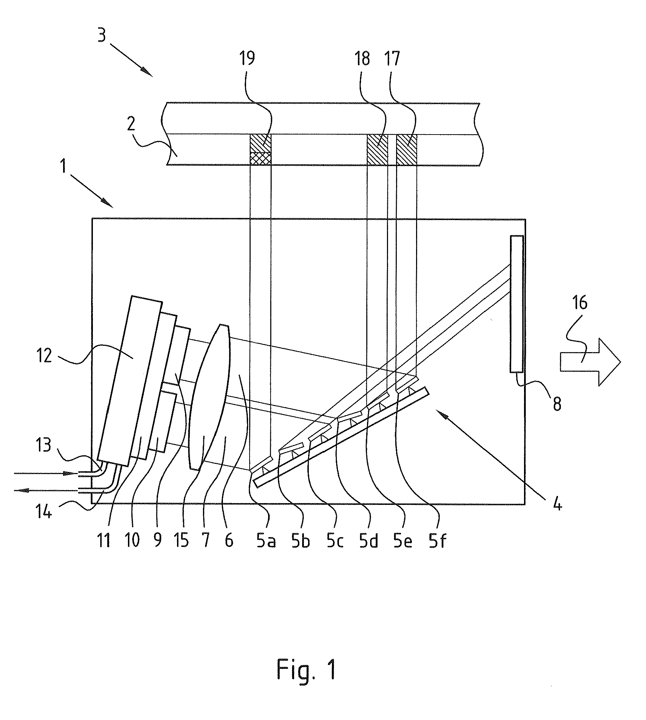

Es gibt nun eine Vielzahl von Möglichkeiten, den erfindungsgemäßen Belichtungskopf oder das erfindungsgemäße Verfahren auszugestalten und weiterzubilden. Hierzu wird beispielsweise verwiesen einerseits auf die von den unabhängigen Patentansprüchen 1 und 13 abhängigen Patentansprüche, andererseits auf die Beschreibung eines Ausführungsbeispiels in Verbindung mit der Zeichnung. In der Zeichnung zeigt die einzige
- Fig. 1: ein Ausführungsbeispiel eines erfindungsgemäßen Belichtungskopfes im Querschnitt.

Der dargestellte Belichtungskopf 1 dient zum selektiven Belichten der photosensitiven Schicht 2 einer Druckform 3, wobei es sich im gezeigten Ausführungsbeispiel um eine Siebdruckform handelt. Dazu weist der Belichtungskopf 1 ein schematisch dargestelltes mikroelektromechanisches Spiegelsystem 4 auf. Es handelt sich um ein mikroelektromechanisches Spiegelsystem 4, das auf dem Prinzip der Reflektion an einer Vielzahl von Mikrospiegeln 5a-f beruht.

Das mikroelektromechanische Spiegelsystem 4 lenkt einen Teil des Lichtes eines ersten Lichtstrahls 6 und eines zweiten Lichtstrahls 7 auf die photosensitive Schicht 2 der Druckform 3 und den anderen Teil auf einen im Belichtungskopf 1 angeordneten Absorber 8. Der erste Lichtstrahl 6 wird dabei von einer ersten Lichtquelle 9 und der zweite Lichtstrahl 7 von einer zweiten Lichtquelle 10 abgegeben. Bei den beiden Lichtquellen 9, 10 handelt es sich um Leuchtdioden, die auf einem gemeinsamen Träger 11 angebracht sind. An dem Träger 11 ist ein Kühlkörper 12 befestigt, um die von den Lichtquellen 9, 10 abgegebene Wärme abzuleiten. Der Kühlkörper 12 wird von Kühlflüssigkeit durchströmt, die durch entsprechende Kühlflüssigkeitsanschlüsse 13, 14 ein- bzw. abgeleitet wird.

Die Strahlform der von den Lichtquellen 9, 10 abgegebenen Lichtstrahlen 6, 7 wird zunächst mit einem optischen Linsensystem 15 angepasst, bevor die Lichtstrahlen 6, 7 unterschiedliche Abschnitte des mikroelektromechanischen Spiegelsystems 4 beleuchten. Ein Teil des ersten Lichtstrahles 6 wird von einer ersten Gruppe von Mikrospiegeln 5d-f auf die photosensitive Schicht 2 der Druckform 3 gelenkt und ein Teil des zweiten Lichtstrahles 7 von einer zweiten Gruppe von Mikrospiegeln 5a-c.

Während des Belichtungsvorganges wird der Belichtungskopf 1 relativ zu der Druckform 3 in der durch den Pfeil 16 angedeuteten Richtung kontinuierlich bewegt, so dass die photosensitive Schicht 2 zuerst von einem Teil des ersten Lichtstrahles 6 und dann von einem Teil des zweiten Lichtstrahles 7 belichtet wird. Die mittlere Wellenlänge des von der ersten Lichtquelle 9 abgegebenen ersten Lichtstrahles 6 ist größer als die des zweiten Lichtstrahles 7. Dies führt dazu, dass an den Stellen 17, 18 der photosensitiven Schicht 2, die ausschließlich mit dem ersten Lichtstrahl 6 belichtet werden, die photosensitive Schicht 2 über die Tiefe gleichmäßig behandelt wird. Bei der darauffolgenden Belichtung mit dem zweiten Lichtstrahl 7, beispielsweise an der Stelle 19, wird dann gezielt der oberflächennahe Bereich der photosensitiven Schicht 2 zusätzlich ausgehärtet.

Im Ergebnis wird die photosensitive Schicht 2 der Druckform 3 somit an den dafür vorgesehenen Stellen 17, 18, 19 in einem ersten Schritt so belichtet, dass eine sichere Härtung über die gesamte Tiefe vorliegt. Anschließend wird mit der zusätzlichen Belichtung mit niedrigerer Wellenlänge die Oberfläche nachgehärtet und somit eine höhere mechanische Beständigkeit der Druckform 3 gewährleistet.

### Bezugszeichen

- 1: Belichtungskopf
- 2: photosensitive Schicht
- 3: Druckform
- 4: mikroelektromechanisches Spiegelsystem
- 5a-f: Mikrospiegel
- 6: erster Lichtstrahl
- 7: zweiter Lichtstrahl
- 8: Absorber
- 9: erste Lichtquelle
- 10: zweite Lichtquelle
- 11: Träger
- 12: Kühlkörper
- 13,14: Kühlflüssigkeitsanschlüsse
- 15: optisches Linsensystem
- 16: Bewegungsrichtung des Belichtungskopfes
- 17,18,19: Stellen der photosensitiven Schicht

## Patentansprüche

1. Belichtungskopf zum selektiven Belichten einer photosensitiven Schicht (2) einer Druckform (3) mit einem mikroelektromechanischen Spiegelsystem (4) und mit mindestens einer einen Lichtstrahl (6,7) abgebenden Lichtquelle (9,10), wobei der Lichtstrahl (6,7) auf das mikroelektromechanische Spiegelsystem (4) gelenkt ist, **dadurch gekennzeichnet, dass** die Lichtquelle (9,10) eine Leuchtdiode ist.

2. Belichtungskopf nach Anspruch 1, **dadurch gekennzeichnet, dass** die Lichtquelle (9,10) ein Dauerlicht abgibt.

3. Belichtungskopf nach Anspruch 1, **dadurch gekennzeichnet, dass** die Lichtquelle (9,10) ein gepulstes Licht abgibt.

4. Belichtungskopf nach einem der Ansprüche 1 bis 3, **dadurch gekennzeichnet, dass** die Lichtquelle (9,10) einen kollimierten Lichtstrahl (6,7) abgibt.

5. Belichtungskopf nach einem der Ansprüche 1 bis 4, **dadurch gekennzeichnet, dass** die Lichtquelle (9,10) einen photonischen Kristall oder ein photonisches Gitter aufweist.

6. Belichtungskopf nach einem der Ansprüche 1 bis 5, **dadurch gekennzeichnet, dass** die mittlere Wellenlänge des von der Lichtquelle (9,10) abgegebenen Lichtstrahles (6,7) zwischen 280 nm und 680 nm, insbesondere zwischen 350 nm und 450 nm, liegt.

7. Belichtungskopf nach einem der Ansprüche 1 bis 6, **dadurch gekennzeichnet, dass** der Belichtungskopf mindestens zwei jeweils einen Lichtstrahl (6,7) abgebende Lichtquellen (9,10) und einen Aktuator zum Lenken jeweils eines Lichtstrahles (6,7) auf das mikroelektromechanische Spiegelsystem (4) umfasst.

8. Belichtungskopf nach einem der Ansprüche 1 bis 7, **dadurch gekennzeichnet, dass** der Belichtungskopf mindestens zwei jeweils einen Lichtstrahl (6,7) abgebende Lichtquellen (9,10) umfasst, wobei die Lichtstrahlen (6,7) gleichzeitig auf das mikroelektromechanische Spiegelsystem (4) gelenkt sind.

9. Belichtungskopf nach einem der Ansprüche 1 bis 8, **dadurch gekennzeichnet, dass** die mittleren Wellenlängen der von den mindestens zwei Lichtquellen (9,10) abgegebenen Lichtstrahlen (6,7) unterschiedlich sind.

10. Verfahren zur Herstellung von Druckformen durch selektive Belichtung deren photosensitiver Schicht mit einem Belichtungskopf, wobei ein Lichtstrahl (6,7) auf ein eine Vielzahl von Mikrospiegeln (5a-f) umfassendes mikroelektromechanisches Spiegelsystem (4) gelenkt wird und wobei die Mikrospiegel (5a-f) in Abhängigkeit von digitalen Signalen derart ausgelenkt werden, dass sie Teile des Lichtstrahles (6,7) auf die photosensitive Schicht (2) einer Druckform (3) lenken, **dadurch gekennzeichnet, dass** der Lichtstrahl (6,7) von einer Leuchtdiode abgegeben wird.

11. Verfahren nach Anspruch 10, **dadurch gekennzeichnet, dass** zwei Lichtstrahlen (6,7) unterschiedlicher Wellenlänge zeitlich nacheinander von dem mikroelektromechanisches Spiegelsystem (4) auf die photosensitive Schichte (2) der Druckform (3) gelenkt werden.

12. Verfahren nach Anspruch 10, **dadurch gekennzeichnet, dass** mindestens zwei Lichtstrahlen (6,7) unterschiedlicher Wellenlänge gleichzeitig von dem mikroelektromechanischen Spiegelsystem (4) auf die photosensitive Schicht (2) der Druckform (3) gelenkt werden.
